# EUROPÄISCHE PATENTANMELDUNG

(11) **EP 2 284 856 A2**
(43) Veröffentlichungstag der Anmeldung: **16.02.2011**
(21) Anmeldenummer: 10007665.2
(22) Anmeldetag: 23.07.2010
(51) Int. Cl.: H01H 37/76, B60R 16/03

(54) **Thermosicherung, insbesondere für ein Leistungsmodul eines Kraftfahrzeugs, sowie Leistungsmodul mit einer derartigen Thermosicherung**

(30) Priorität: 07.08.2009 DE 102009036578
(71) Anmelder: Magna Electronics Europe GmbH & Co. KG, 63877 Seilauf (DE)
(72) Erfinder: Wenzel, Diethard, 79771 Klettgau (DE)
(74) Vertreter: Patentanwälte Westphal, Mussgnug & Partner

(57) **Zusammenfassung**

Die Erfindung betrifft eine Thermosicherung (1), insbesondere für ein Leistungsmodul (5) eines Kraftfahrzeugs, mit einer Leiterbahn (10), die auf einer Platine (11) angeordnet und durch eine Trennstelle (20) unterbrochen ist, und die jeweils benachbart zur Trennstelle (20) einen ersten Leiterbahnabschnitt (12) und einen zweiten Leiterbahnabschnitt (14) aufweist, einer Kontaktbrücke (30), die im Bereich der Trennstelle (20) angeordnet ist, und einander gegenüberliegend einen ersten Kontaktabschnitt (32) und einen zweiten Kontaktabschnitt (34) aufweist. Die Kontaktabschnitte (32, 34) sind in einer ersten Position an den Leiterbahnabschnitten (12, 14) mittels Lot an Lotstellen (42, 44) befestigt. Die Kontaktbrücke (30) ist in der ersten Position mittels Federkraft beaufschlagt, derart, dass bei Erreichen des Schmelzpunktes des Lots die Kontaktabschnitte (32, 34) von den korrespondierenden Leiterbahnabschnitten (12, 14) getrennt werden. Ferner weist die Thermosicherung (1) ein Federelement (60) auf, das bei Erreichen des Schmelzpunktes des Lots eine Bewegung der Kontaktbrücke (30) aus der ersten Position in eine zweite Position auslöst, wobei die Bewegung der Kontaktbrücke (30) parallel zur Platine (11) verläuft und die Kontaktbrücke (30) in der zweiten Position fixierbar ist, ohne dass die Kontaktbrücke (30) den ersten Leiterbahnabschnitt (12) kontaktiert.

## Beschreibung

Die Erfindung betrifft eine Thermosicherung, insbesondere für ein Leistungsmodul eines Kraftfahrzeugs, gemäß Oberbegriff des Anspruchs 1. Die Erfindung betrifft weiterhin ein mit einer derartigen Thermosicherung ausgestattetes Leistungsmodul.

Aus der DE 10 2005 040 308 B4 ist eine Thermosicherung bekannt, bei der eine Kontaktbrücke Leiterbahnabschnitte miteinander verbindet, solange die Kontaktbrücke mittels Lot an den Leiterbahnabschnitten befestigt bleibt. Bei Erreichen des Schmelzpunktes des Lots wird die Kontaktbrücke, die im Bereich einer eine Leiterbahn unterbrechenden Trennstelle angeordnet ist von den entsprechenden Leiterbahnabschnitten getrennt. Möglicherweise löst sich auch nur ein Lot. Unterstützt wird die Trennung der Kontaktbrücke von mindestens einem Leiterbahnabschnitt durch ein Federelement, das bei Erreichen des Schmelzpunktes des Lots eine translatorische Verschiebbewegung der Kontaktbrücke auslöst.

Sicherheitsvorschriften zu solchen Thermosicherungen akzeptieren es nicht, dass eine solche Kontaktbrücke mehr oder weniger lose in der Thermosicherung verbleibt. Anliegen solcher Vorschriften ist es, eine zufällige Kontaktierung unter Herstellung der ursprünglichen Leitungen auszuschließen. Hierin besteht das Problem der vorliegenden Erfindung.

Weiterer Verbesserungsbedarf wird darin gesehen, die Herstellung solcher Thermosicherungen bzw. Leistungsmodule kostengünstiger zu gestalten.

Gelöst wird dieses Problem durch eine Thermosicherung mit den Merkmalen des Anspruchs 1 sowie durch ein Leistungsmodul mit den Merkmalen des Anspruchs 9.

Vorteilhafte Ausgestaltungsformen der Erfindung sind durch die Merkmale der jeweils hierauf rückbezogenen Unteransprüche angegeben.

Erfindungsgemäße Thermosicherungen eignen sich insbesondere für Leistungsmodule von Kraftfahrzeugen. Solche Leistungsmodule sind vor Überhitzungen zu schützen; nicht zuletzt aus Sicherheitsgründen.

Dazu weist die Thermosicherung eine Leiterbahn auf, die auf einer Platine angeordnet und durch eine Trennstelle unterbrochen ist. Auf einer Seite der Trennstelle befindet sich ein erster Leiterbahnabschnitt. Auf der anderen Seite der Trennstelle befindet sich ein zweiter Leiterbahnabschnitt. Zur Überbrückung der Trennstelle ist im Bereich der Trennstelle eine Kontaktbrücke angeordnet. Die Kontaktbrücke weist einander gegenüber liegend einen ersten Kontaktabschnitt und einen zweiten Kontaktabschnitt auf. Die Kontaktabschnitte sind insbesondere als Enden der Kontaktbrücke, derart voneinander beabstandet, dass dies etwa einer Distanz zwischen dem ersten Leiterbahnabschnitt und dem zweiten Leiterbahnabschnitt entspricht. Somit sind die Kontaktabschnitte in einer ersten Position an den Leiterbahnabschnitten anliegend angeordnet. In der ersten Position sind die Kontaktabschnitte an den Leiterbahnabschnitten mittels Lot befestigt.

Die Kontaktbrücke ist grundsätzlich beweglich ausgeführt. In der ersten Position allerdings ist die Kontaktbrücke in den besagten Abschnitten an der Platine befestigt. Auf die Kontaktbrücke kann wegen der Befestigung zunächst ein Potential wirken, ohne dass sich die Kontaktbrücke bewegen kann. Sobald die Befestigung an der Platine gelöst wird, führt das Potential die Bewegung der Kontaktbrücke herbei. Erfindungsgemäß ist als Potential eine Beaufschlagung mittels Federkraft vorgeschlagen, wozu gleichwirkende Alternativen bestehen. Die Ausnutzung von Zentrifugal- oder Schwerkraft kommt ebenso als Potential in Frage, wie auch bspw. Magnetkraft oder Vergleichbares.

Kommt es nun zum Erreichen des Schmelzpunktes des Lots und somit zum Lösen der Befestigung der Kontaktbrücke an der Platine oder zumindest einem Leiterbahnabschnitt, führt dies zu einer Trennung mindestens eines Kontaktabschnittes von dem korrespondierenden Leiterbahnabschnitt, so dass kein elektrischer Strom über die Trennstelle hinweg geleitet wird. Dabei wirkt das oben angesprochene Potential, so dass sich die Kontaktbrücke in eine zweite Position bewegt. Bspw. wirkt ein Federelement, das bei Erreichen des Schmelzpunktes des Lots eine Bewegung der Kontaktbrücke aus der ersten Position in die zweite Position auslöst.

Ein Aspekt liegt darin, die Bewegung der Kontaktbrücke parallel zur Platine auszurichten. Somit kann ein gewisser Federweg zurückgelegt werden, wenn sich auf beiden Seiten der Kontaktbrücke die Lotstellen lösen, ohne dass sich die Kontaktbrücke von der Platine bspw. senkrecht zur Platine entfernen müsste.

Ein weiterer Aspekt besteht darin, dass die Kontaktbrücke in der zweiten Position fixierbar ist, bspw. an der Platine. Alternativ kann die Kontaktbrücke auch in einem Gehäuse fixierbar sein, in das die Thermosicherung einzusetzen ist. In der zweiten Position ist die Kontaktierung zwischen Kontaktbrücke und dem ersten Leiterbahnabschnitt ausgeschlossen. Es handelt sich hierbei demnach um eine qualifizierte Fixierung, die erst dann eintritt, wenn die Kontaktbrücke eine gewisse Wegstrecke parallel zur Platine zurückgelegt hat. Hierbei wird auch klar, dass sich die beiden Erfindungsgedanken ergänzen, da die Führung parallel zur Platine auch die qualifizierte Fixierbarkeit bedingt.

In einer bevorzugten Ausführungsform ist die Kontaktbrücke in der zweiten Position selbsttätig fixierbar.

Eine selbsttätige Fixierung der Kontaktbrücke in der zweiten Position ist besonders vorteilhaft, da eine zufällige Kontaktierung der Kontaktbrücke mit dem ersten Leiterbahnabschnitt unter wenn auch nur kurzfristiger Überbrückung der Trennstelle sicher vermieden ist. Denkbar sind Rastmechanismen zur Fixierung der Kontaktbrücke in der zweiten Position.

In einer bevorzugten Ausführungsform ist die Kontaktbrücke in der zweiten Position selbsttätig an der Platine fixierbar. Dies kann bspw. mittels Lot an der Leiterbahn realisiert sein, besonders bevorzugt mittels Lot zwischen dem zweiten Kontaktbereich der Kontaktbrücke und dem zweiten Leiterbahnabschnitt der Platine.

Besonders vorteilhaft scheint aber die Ausführungsform zu sein, bei der ein nach wie vor an der Kontaktbrücke im zweiten Kontaktbereich vorhandenes Lot in der zweiten Position erneut erkaltet, um die Kontaktbrücke, insbesondere an dem zweiten Leiterbahnabschnitt oder einem dritten Leiterbahnabschnitt, an der Platine zu fixieren. Dabei erstreckt sich der zweite Leiterbahnabschnitt bevorzugt über eine gewisse Distanz, so dass er auch in der zweiten Position noch von der Kontaktbrücke erreicht wird. Die andere Seite der Trennstelle, nämlich der erste Leiterbahnabschnitt, kann in der zweiten Position nicht mehr durch die Kontaktbrücke erreicht werden. Alternativ kann auch ein dritter Leiterbahnabschnitt vorgesehen sein, mit dem die Kontaktbrücke an der zweiten Position in Kontakt tritt.

In einer vorteilhaften Ausführungsform ist die Kontaktbrücke an mindestens einer Schiene längs verschiebbar geführt. Die Schiene muss dabei derart angeordnet sein, dass die Kontaktbrücke in sämtlichen Querrichtungen zur Verschiebebewegung abgestützt ist, die bekanntlich parallel zur Platine verläuft. Dazu ist die Schiene bspw. auf der Platine angeordnet. Alternativ kann die Schiene auch in dem Gehäuse angeordnet sein, insbesondere im Gehäuse ausgeformt sein.

Besonders vorteilhaft erscheint hierbei, dass kompakte Bauformen möglich sind, die eine sichere Führung der Kontaktbrücke gewährleisten, ohne dass es zu Verkantungen kommen kann und ein definiertes Ziel des Verschiebewegs vordefinierbar ist.

In einer vorteilhaften Ausführungsform ist auf der Platine mindestens ein Anschlag angeordnet. Der Anschlag befindet sich von der Kontaktbrücke aus gesehen dem Federelement gegenüberliegend. Der Anschlag kann somit die Verschiebebewegung der Kontaktbrücke begrenzen, die von dem Federelement ausgelöst ist. Der Anschlag dient somit vorteilhafterweise der Abstützung der Kontaktbrücke in der zweiten Position.

Die Ausführungsform mit einem solchen Anschlag gewährleistet besonders vorteilhaft die sichere Positionierung der Kontaktbrücke in der mittels des Anschlags definierten zweiten Position.

In einer vorteilhaften Ausführungsform ist das Federelement ein Druckfeder-Element, insbesondere eine Spiralfeder. Das Federelement ist zwischen einem Gehäuse, in welches die Thermosicherung einsetzbar ist, und der Kontaktbrücke wirkend angeordnet.

Bei dieser Auswahl aus möglichen Federelementen handelt es sich um ein robustes, kostengünstiges Federelement mit langer Lebensdauer. Auch die Anordnung zwischen Gehäuse und Kontaktbrücke erscheint durch ein derartiges Federelement besonders vorteilhaft realisierbar zu sein, weil mit Druckfeder-Elementen eine Führung über eine relativ weite Distanz gelingen kann, so dass auch in der zweiten Position noch eine Kontaktierung der Kontaktbrücke erreicht werden kann.

In einer vorteilhaften Ausführungsform ist auf der Platine ein Führungselement für das Federelement angeordnet. Bspw. kann das Führungselement in Form einer Hülse ausgestaltet sein. Alternativ kann das Federelement zentral geführt werden, bspw. auf einem Dorn. Die Führung in einem Führungselement dient hierbei vorteilhaft gleichzeitig der Aufnahme des Federelements. Somit ist eine Vormontage auf der Platine realisierbar, so dass die Platine mit dem Federelement in das Gehäuse einschiebbar oder einsetzbar ist, ohne dass das Federelement dabei in eine falsche Position geraten kann. Falsch wäre eine Position des Federelements, die eine Wirkung in der vorgesehenen Bewegungsrichtung der Verschiebebewegung der Kontaktbrücke nicht ermöglicht.

In einer vorteilhaften Ausführungsform ist ein Käfig auf der Platine angeordnet, der die mindestens eine Schiene, den Anschlag und das Führungselement umfasst. Ein solcher Käfig vereint somit die durch die Schiene, den Anschlag und/oder das Führungselement übernommenen Funktionen.

Ein derartiger Käfig kann besonders vorteilhaft kostengünstig aus einem Kunststoffteil bestehen, dass vorgefertigt werden kann. Dieses Kunststoffteil kann bspw. die Kontaktbrücke umgebend auf der Platine vormontiert werden. Somit entstehen auch hinsichtlich der Montageschritte deutliche Fertigungsvorteile.

Die Kontaktbrücke einer vorteilhaften Ausführungsform ist als Stanzteil ausgebildet.

Hierdurch ergeben sich auch hinsichtlich der Fertigung der Kontaktbrücke Kostenvorteile.

Besonders vorteilhaft werden solche Thermosicherungen in Leistungsmodulen für Kraftfahrzeuge eingesetzt.

### Ausführungsbeispiel

Die Erfindung wird näher anhand des in den Figuren dargestellten Ausführungsbeispiels erläutert.

Es zeigen:
- Fig. 1: Thermosicherung, bereitgestellt ohne Vorspannung,
- Fig. 2: vorgespannte Thermosicherung gemäß Fig. 1 mit Kon- taktbrücke in erster Position und
- Fig. 3: ausgelöste Thermosicherung gemäß Fig. 1 mit Kontakt- brücke in zweiter Position.

Sämtliche Figuren zeigen perspektivische Ansichten auf einen Ausschnitt der Platine 11 und auf einen Gehäuseabschnitt 70, wobei die Thermosicherung 1 auf der Platine 11 angeordnet ist.

Die Thermosicherung 1 umfasst als zentrales Element eine Kontaktbrücke 30, die parallel zur Platine 11 verschiebbar auf der Platine 11 in einem Käfig 18, 19, 62 geführt ist. Dem Gehäuseabschnitt 70 zugewandt umfasst der Käfig 18, 19, 62 eine Hülse 62 zur Aufnahme eines Federelements 60, insbesondere einer Schraubenfeder.

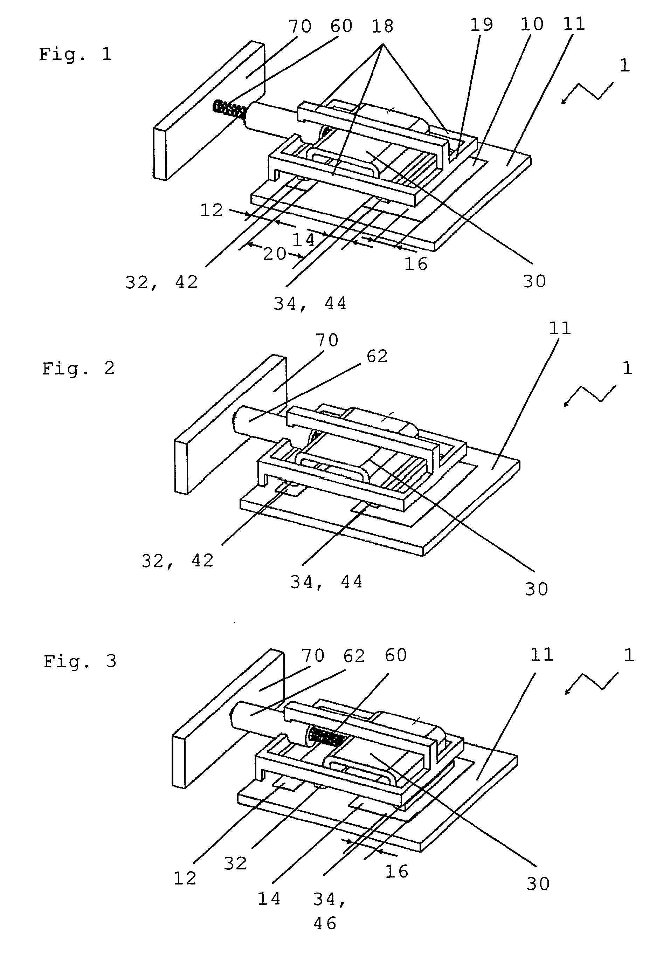

In Figur 1 befindet sich die Kontaktbrücke 30 in einer ersten Position. Das Federelement 60 ist bereits in Kontakt mit dem Gehäuseabschnitt 70, wobei das Federelement 60 lediglich ohne Vorspannung des Federelements 60 teilweise in die Hülse 62 eingerückt ist.

In Figur 2 ist das Federelement 60 gegen die Kontaktbrücke 30 vorgespannt, wobei sich die Kontaktbrücke 30 nach wie vor in der ersten Position befindet. Dazu ist die Kontaktbrücke 30 an der Platine 11 fixiert. Die Vorspannung des Federelements 60, das nun nahezu vollständig in der Hülse 62 versunken ist, resultiert aus einer Relativbewegung zwischen Platine 11 mit darauf befestigtem Käfig 18, 19, 62 und dem Gehäuseabschnitt 70.

Figur 3 zeigt die Kontaktbrücke 30 in einer zweiten Position. Zum Erreichen der zweiten Position hat die Kontaktbrücke 30 eine translatorische Verschiebebewegung parallel zur Platine 11 gemacht. Dazu Anlass gegeben hat ein Lösen der Fixierung der Kontaktbrücke 30 auf der Platine 11. Begründet ist die Verschiebebewegung jedoch durch die Federkraft, die durch das gespannte Federelement 60 auf die Kontaktbrücke 30 wirkt. Auch wenn eine Fixierung der Kontaktbrücke 30 bereits durch die Führung im Käfig 18, 29, 62 und das gestreckte Federelement 60 gegeben ist, kommt es erfindungsgemäß in der zweiten Position der Kontaktbrücke 30 zusätzlich zu einer selbsttätigen Fixierung der Kontaktbrücke 30, insbesondere zu einer Fixierung der Kontaktbrücke 30 an der Platine 11. Alternativ könnte eine solche Fixierung der Kontaktbrücke 30 zusätzlich in entsprechenden Einrichtungen eines Gehäuses realisiert sein (nicht näher dargestellt).

Die oben anhand der beiden Positionen der Kontaktbrücke 30 beschriebene Verschiebebewegung der Kontaktbrücke 30 bewirkt eine Unterbrechung einer elektrischen Leitung bei Überschreiten einer gewissen Temperatur. Dazu ist die Platine 11 wie folgt gestaltet:
Die Platine 11 weist eine Leiterbahn mit der Funktion der elektrischen Leitung auf, die durch eine Trennstelle 20 unterbrochen ist. Die Leiterbahn endet zur Trennstelle 20 hin auf beiden Seiten mit einem ersten Leiterbahnabschnitt 12 und einem zweiten Leiterbahnabschnitt 14. Zur Übernahme der Funktion der elektrischen Leitung über die Trennstelle 20 hinweg ist die Kontaktbrücke 30 in ihrer ersten Position die Leiterbahnabschnitte 12, 14 kontaktierend und die Trennstelle 20 überspannend auf der Leiterbahn bzw. der Platine 11 angeordnet.
Die Kontaktbrücke 30 kontaktiert die Leiterbahnabschnitte 12, 14 mit einem ersten Kontaktabschnitt 32 bzw. einem zweiten Kontaktabschnitt 34. Die Kontaktbrücke 30 ist bei der jeweiligen Paarung, erster Kontaktabschnitt 32 zum ersten Leiterbahnabschnitt 12 und zweier Kontaktabschnitt 34 zum zweiten Leiterbahnabschnitt 14, mittels Lot an einer ersten Lötstelle 42 und einer zweiten Lötstelle 44 auf der Leiterbahn befestigt.

Bei entsprechender Temperaturerhöhung löst sich das Lot 42, 44 in der Regel an beiden Stellen. Der Kontakt zu den beiden Leiterbahnabschnitten 12, 14 bleibt jedoch bei der erfindungsgemäßen Ausgestaltung jedenfalls erhalten bis beide Lotstellen 42, 44 an- oder aufgeschmolzen sind. Erst dann kommt es zu einer Verschiebebewegung parallel zur Platine 11 zur Kontaktbrücke 30 in eine zweite Position der Kontaktbrücke 30.

In der zweiten Position der Kontaktbrücke 30 erreicht die Kontaktbrücke 30 den ersten Leiterbahnabschnitt 12 nicht mehr, so dass die Trennstelle 20 nicht mehr überbrückt ist und elektrischer Strom nicht mehr über die Trennstelle 20 hinweggeleitet werden kann. Der erste Kontaktabschnitt 32 der Kontaktbrücke 30 ruht in der zweiten Position (Figur 3) auf einem elektrisch nicht leitenden Bereich der Platine 11. Alternativ zur Darstellung gemäß Figur 3 kann unterhalb des ersten Kontaktbereichs in der zweiten Position der Kontaktbrücke 30 ein Leiterbahnabschnitt einer zweiten Leiterbahn angeordnet sein.

Der zweite Kontaktabschnitt 34 der Kontaktbrücke 30 erreicht in der zweiten Position einen dritten Leiterbahnabschnitt 16 benachbart zum zweiten Leiterbahnabschnitt 14. Der zweite Leiterbahnabschnitt 14 kann auch besonders breit in Verschieberichtung der Kontaktbrücke 30 ausgebildet sein, so dass der zweite Kontaktbereich 34 auch in der zweiten Position noch den zweiten Leiterbahnabschnitt 14 erreicht.

Sinkt die Temperatur wieder, erfolgt in der zweiten Position eine selbsttätige Fixierung der Kontaktbrücke 30 auf der Platine 11 durch ein Lot zwischen dem zweiten Kontaktbereich 34 und dem zweiten bzw. dritten Leiterbahnabschnitt 14, 16. Bei der Verschiebebewegung der Kontaktbrücke 30 nimmt die Kontaktbrücke 30 einen Teil des Lots, das vorher zur Befestigung am zweiten Leiterbahnabschnitt 14 gedient hat, von einer zweiten Lötstelle 44 mit in die zweite Position zu einer dritten Lötstele 46, so dass das Lot hier zur selbsttätigen Fixierung erneut zur Verfügung steht.

Wie aus den Figuren 1 bis 3 deutlich wird, kann die gesamte Thermosicherung 1 als eine vorzubereitende Baugruppe inklusive Federelement 60 vormontiert werden und als solche in ein Gehäuse eingeschoben werden. Auch wenn nur mit dem Bezugszeichen 70 gekennzeichnet ein Gehäuseabschnitt eines, vorzugsweise das gesamte Thermosicherung 1 umgebenden, Gehäuses dargestellt ist, ist leicht vorstellbar, in welcher Art von Gehäuse eine solche Thermosicherung 1 einschiebbar ist. Hierzu ist darüber hinaus in der DE 10 2005 040 308 A1 ausreichend Anregung gegeben.

### Bezugszeichenliste

- 1: Thermosicherung

- 10: Leiterbahn
- 11: Platine
- 12: erster Leiterbahnabschnitt
- 14: zweiter Leiterbahnabschnitt
- 16: dritter Leiterbahnabschnitt
- 18: Schiene
- 19: Anschlag

- 20: Trennstelle

- 30: Kontaktbrücke
- 32: erster Kontaktabschnitt
- 34: zweiter Kontaktabschnitt

- 42: erste Lötstelle
- 44: zweite Lötstelle
- 46: dritte Lötstelle

- 60: Schraubenfeder
- 62: Hülse

- 70: Gehäuseabschnitt

## Patentansprüche

1. Thermosicherung (1), insbesondere für ein Leistungsmodul (5) eines Kraftfahrzeugs, mit
1.1 einer Leiterbahn (10), die auf einer Platine (11) angeordnet und durch eine Trennstelle (20) unterbrochen ist, und die jeweils benachbart zur Trennstelle (20) einen ersten Leiterbahnabschnitt (12) und einen zweiten Leiterbahnabschnitt (14) aufweist,
1.2 einer Kontaktbrücke (30), die im Bereich der Trennstelle (20) angeordnet ist, und einander gegenüberliegend einen ersten Kontaktabschnitt (32) und einen zweiten Kontaktabschnitt (34) aufweist, wobei
1.3 die Kontaktabschnitte (32, 34) in einer ersten Position an den Leiterbahnabschnitten (12, 14) mittels Lot an Lotstellen (42, 44) befestigt sind, und wobei
1.4 die Kontaktbrücke (30) in der ersten Position mittels Federkraft beaufschlagt ist, derart, dass
1.5 bei Erreichen des Schmelzpunktes des Lots die Kontaktabschnitte (32, 34) von den korrespondierenden Leiterbahnabschnitten (12, 14) getrennt werden, und mit
1.6 einem Federelement (60), das bei Erreichen des Schmelzpunktes des Lots eine Bewegung der Kontaktbrücke (30) aus der ersten Position in eine zweite Position auslöst, **dadurch gekennzeichnet, dass**
1.7 die Bewegung der Kontaktbrücke (30) parallel zur Platine (11) verläuft und
1.8 die Kontaktbrücke (30) in der zweiten Position fixierbar ist, ohne dass die Kontaktbrücke (30) den ersten Leiterbahnabschnitt (12) kontaktiert.

2. Thermosicherung (1) nach Anspruch 1,
**dadurch gekennzeichnet, dass** die Kontaktbrücke (30) in der zweiten Position selbsttätig fixierbar ist, insbesondere mittels Lot und besonders bevorzugt mit dem zweiten Kontaktbereich (34) an dem zweiten Leiterbahnabschnitt (14).

3. Thermosicherung (1) nach einem der Ansprüche 1 oder 2, deren Kontaktbrücke (30) an mindestens einer Schiene (18) längsverschieblich geführt ist, wobei die mindestens eine Schiene (18) insbesondere auf der Platine (11) derart angeordnet ist, dass die Kontaktbrücke (30) in sämtlichen Querrichtungen zur Verschiebebewegung abgestützt ist.

4. Thermosicherung (1) nach einem der vorangehenden Ansprüche,
auf deren Platine (11) mindestens ein Anschlag (19) zur dem Federelement (60) gegenüberliegenden Begrenzung der Verschiebebewegung angeordnet ist, sodass die Kontaktbrücke (30) in der zweiten Position an dem Anschlag (19) anliegt.

5. Thermosicherung (1) nach einer der vorangehenden Ansprüche,
deren Federelement (60) ein Druckfeder-Element (60), bevorzugt eine Spiralfeder, ist, das zwischen einem Gehäuse (70), in welches die Thermosicherung (1), insbesondere gemeinsam mit der Platine (11) einsetzbar ist, und der Kontaktbrücke (30) wirkend angeordnet ist.

6. Thermosicherung (1) nach einem der vorangehenden Ansprüche, auf deren Platine (11) ein Führungselement für das Federelement (60), insbesondere in Form einer Hülse (62), angeordnet ist.

7. Thermosicherung nach den Ansprüchen 3, 4 und 6,
**gekennzeichnet durch** einen auf der Platine (11) angeordneten Käfig, der die mindestens eine Schiene (18), den Anschlag (19) und / oder das Führungselement umfasst.

8. Thermosicherung nach einem der vorhergehenden Ansprüche, **dadurch gekennzeichnet, dass** die Kontaktbrücke (12, 14) als Stanzteil ausgebildet ist.

9. Leistungsmodul (5) für ein Kraftfahrzeug mit einer Thermosicherung (1) nach einem der vorhergehenden Ansprüche.
